# EUROPEAN PATENT SPECIFICATION

(11) **EP 3 061 132 B1**
(45) Date of publication and mention of the grant of the patent: **15.11.2017**
(21) Application number: 14806724.2
(22) Date of filing: 23.10.2014
(51) Int. Cl.: H01L 27/144, H01L 27/146, G01T 1/24

(54) **IMPROVED SOLID-STATE PHOTOMULTIPLIER DEVICE AND METHOD FOR CONTROLLING SAID PHOTOMULTIPLIER DEVICE**
VERBESSERTE RÖHRENLOSE PHOTOVERVIELFACHERVORRICHTUNG UND VERFAHREN ZUM STEUERN DIESER PHOTOVERVIELFACHERVORRICHTUNG
DISPOSITIF PHOTOMULTIPLICATEUR À SEMI-CONDUCTEURS AMÉLIORÉ ET PROCÉDÉ DE COMMANDE DUDIT DISPOSITIF PHOTOMULTIPLICATEUR

(30) Priority: 25.10.2013 IT VI20130263
(43) Date of publication of application: 31.08.2016
(73) Proprietor: Fondazione Bruno Kessler, 38122 Trento (IT)
(72) Inventor: PIEMONTE, Claudio, I-38057 Pergine Valsugana (TN) (IT); GOLA, Alberto, I-38123 Trento (IT)
(74) Representative: Marchioro, Paolo
(86) International application number: PCT/IB2014/065566
(87) International publication number: WO 2015/059663

(56) References cited:
- DE-A1-102012 204 806
- US-A1- 2012 318 989
- US-A1- 2013 153 975

## Description

The present invention concerns an improved solid-state photomultiplier device suited to detect one or more photons impacting the sensitive surface of said device.

The invention also concerns a method for controlling said photomultiplier device.

It is known that there are many fields of application in which it is necessary to detect very low intensity light.

In the medical field, for example, said need can be observed in the equipment for the application of the technique known as positron emission tomography (PET), by means of which it is possible to obtain bio-images that allow the creation of maps of the functional processes within the human body.

In particular, according to said technique a radioactive tracer isotope is administered to the body of the patient undergoing the examination, wherein said radioactive tracer isotope, following a process of decay, emission of positrons and annihilation of the latter with electrons, causes the emission of two photons in opposite directions.

Said photons, on reaching a scintillator material placed in the scanning device, generate a flash of light that is detected by said photomultiplier devices.

In these specific cases, as well as in other applications, the object is to "count" the number of photons and usually also to establish, as precisely as possible, the instant of arrival of the high energy particle.

In order to allow said detection operation to be carried out, it is therefore necessary to use photomultiplier devices with high performance efficiency, which can be quantified by a high time and energy resolution, by the number of photons generated in the flash of light, and by the limited, if not absent, problems of sensitivity to intrinsic and/or external interferences.

It is known that solid-state photomultiplier devices have been recently developed which in technical jargon are called "silicon photomultipliers" or "SiPMs" and which here below, if not expressly indicated otherwise, are simply referred to as photomultiplier devices. Document US2012/0318989 shows a silicon photomultiplier. These photomultiplier devices comprise a plurality of light sensitive microcells usually arranged as a matrix on a single semiconductor substrate. Each one of said light sensitive microcells comprises a reversely polarized avalanche photodiode that responds independently of the others, emitting an elementary charge packet in the moment when a photon is detected. Each light sensitive microcell furthermore comprises a quenching circuit that is connected to the photodiode in series and is suited to quench said avalanche effect that was established in the same photodiode following the impact of a photon on its sensitive surface.

In particular, there are two distinct types of quenching circuit, respectively the passive type and the active type, each one of which has the advantages and the disadvantages described below.

Concerning the quenching mode of the passive type, the relative circuit is implemented with a resistor, arranged in series with respect to the photodiode, which limits the value of the avalanche current until quenching it.

Concerning, instead, the quenching mode of the active type, the relative circuit is implemented by means of a voltage driver that makes it possible to set the polarization voltage between the ends of the photodiode. In particular, the driver is active for two limited time intervals that correspond to the discharge of the photodiode, that is, the period when it is necessary to quench said avalanche effect, and to the charge of the same photodiode, that is, the period when it is necessary to polarize the photodiode reversely following the quenching of the avalanche effect.

With the exclusion of said two time intervals, the driver remains at high impedance, leaving the photodiode either charged at the polarization voltage imposed during the charge phase or, advantageously and contrary to the passive approach, in a state of polarization below the breakdown voltage **V_{BD}**, where no avalanche is generated, for a time period that can be set and that in technical jargon is called "detector idle time". Said last characteristic, as is explained below, makes it possible to reduce the "correlated" noise that can be observed in the photomultiplier device as, by choosing a suitable idle time value, it is possible to inhibit the so-called "Afterpulsing" phenomenon that is explained in greater detail below.

However, to disadvantage, in most of the technologies used at present to implement the active quenching circuit, the reaction time of the same circuit following the generation of an avalanche in the photodiode is much longer than the discharge time of the junction of said photodiode. Therefore, notwithstanding the above mentioned advantages obtained with an active quenching circuit, the latter is usually combined with a passive quenching circuit. Moreover, as the space occupied by an active quenching circuit is such that it is not possible to integrate it in each light sensitive microcell of a photomultiplier device, if not with an excessive loss of light sensitive area, the photomultiplier devices presently available on the market are provided exclusively with a passive quenching circuit.

It is also known that presently there are two types of solid-state photomultiplier devices, depending on how the output signals of the single photodiodes are treated.

A first type is constituted by digital photomultiplier devices (dSiPMs), in which the signals of the individual photodiodes are digitalized locally, generally at the level of each individual microcell, and sent to a logic unit placed on the same surface on which said light sensitive microcells are provided. For the implementation of these functions, said dSiPMs are usually made with a modified CMOS technology, which makes it possible to integrate different logic functions directly in the device.

Said logic unit supplies output data relating to the detection of the incident photons.

The second type of photomultiplier devices is constituted by analog photomultiplier devices (aSiPMs) that emit a single analog output signal that is proportional to the number of light sensitive microcells activated, that is, proportional to the number of photodiodes on which the impact of one or more photons has occurred.

For this purpose, the photodiode of each light sensitive microcell of the latter type of photomultiplier devices is connected in parallel to the photodiodes of the other light sensitive microcells and, consequently, the currents generated by the single microcells while a flash of light is detected are summed together. Said two types of solid-state photomultiplier devices have advantages and disadvantages with respect to each other, and these are described here below. Concerning the photomultiplier devices of the digital type, advantageously these, thanks to the local implementation of digital logic circuits, make it possible to inhibit at a logic level, in a simple manner, any light sensitive microcells that are not working or are very noisy, differently from the photomultiplier devices of the analog type, in which the inhibition of said light sensitive microcells is not possible unless a physical operation is carried out on the electrical connections.

In greater detail, the factors that determine the noisiness of a light sensitive microcell are mainly the so-called "Dark Count Rate" or DCR, the already mentioned "Afterpulsing" or AP, and the "Optical Cross-talk" or OC phenomenon. The term "Dark Count Rate" means the probability of generation of the avalanche effect on a photodiode of a light sensitive microcell in the time unit due to the thermal generation of charge carriers in the silicon at the level of the sensitive area, in the absence of impact of a photon on said area, from which the term Dark Count (DC) is derived. Therefore, said type of noise is not correlated with the detection of a photon. The term "Afterpulsing", instead, means the probability of generation of the avalanche effect on a photodiode due to the release of carriers trapped in the active area of the same photodiode during a previous avalanche caused by the detection of a photon or by said DCR. Said phenomenon, therefore, differently from said "Dark Count Rate", is correlated with the detection of an event, photon or DC, by the photodiode. Finally, the term "Optical Cross-talk" refers to that phenomenon in which, when an avalanche is generated in a single light sensitive microcell, the so-called "hot carriers" emit a certain number of photons that can be absorbed and can determine the generation of an avalanche in another light sensitive microcell belonging to the same photomultiplier device.

Going back to the comparison between the two types of solid-state photomultiplier devices, a further advantage offered by digital photomultipliers compared to analog photomultipliers lies in that their time resolution is substantially independent of the size of the device itself.

On the other hand, analog photomultiplier devices have a simpler construction structure and are also easier to manage compared to digital photomultipliers. Therefore, photomultiplier devices of the analog type have lower production costs compared to digital photomultiplier devices and so in some situations it is preferable to use the former.

Furthermore, the sensitive surface of analog photomultipliers is independent of the logic unit that manages the output signals emitted by the photodiodes, as the connection between the two entities is obtained through discrete connection means (wire bonds or the like), differently from digital photomultiplier devices in which, as already mentioned above, the logic unit is usually obtained on the same surface on which the photodiodes are provided. Consequently and advantageously, analog photomultiplier devices make it possible to intervene on the logic unit independently of the sensitive surface and vice versa.

Furthermore, the fact that digital photomultiplier devices are provided with the logic unit on the surface on which there are the light sensitive microcells determines the presence of a "dead" area that is not sensitive to the impact of photons and that, in turn, determines a decrease in the so-called "Fill Factor" or FF, defined as the ratio between the surface that is actually light sensitive and the entire area occupied by the photomultiplier device.

The compared analysis of the two types of solid-state photomultiplier devices described above thus shows the drawbacks of the known art.

The present invention intends to overcome the above mentioned drawbacks.

In particular, it is the object of the invention to provide a photomultiplier device of the analog type that has a higher efficiency index than the analog devices of the known art.

In particular, it is the object of the invention to provide a photomultiplier device of the analog type that, following a phase of recharge of the entire light sensitive surface, is capable of automatically and rapidly inhibiting those light sensitive microcells that are considered highly noisy, meaning those microcells that have a high "Dark Count Rate".

It is a further object of the invention to provide a photomultiplier device that is capable of limiting, if not eliminating, the so-called phenomenon of "Afterpulsing" in the individual light sensitive microcells.

It is also the object of the invention to provide a photomultiplier device that makes it possible to increase the FF, considering a light sensitive microcell having the same size, compared to the photomultiplier devices of the known art, or that makes it possible to reduce the size of the light sensitive microcells while at the same time maintaining a high FF value.

Furthermore, it is another object of the invention to provide a photomultiplier device with higher production efficiency compared to the photomultiplier devices of the known art, owing to the generation of a smaller number of rejects during production.

In particular, thanks to the fact that with the photomultiplier device of the invention it is possible to inhibit the highly noisy light sensitive microcells, which are called "screamers" in technical jargon, during production it will no more be necessary to reject the photomultiplier devices with a high but reasonable number of said "screamers".

It is another, yet not the least object of the invention to provide a photomultiplier device of the analog type integrating some structural and functional characteristics that are typical of digital photomultiplier devices, which allow the advantages defined above to be achieved while at the same time maintaining a lower production cost compared to said digital devices. The objects described above are achieved by a photomultiplier device having the characteristics illustrated in the main claim.

In particular, the photomultiplier device that is the subject of the invention is of the analog type, that is, it comprises a plurality of avalanche photodiodes connected to one another in parallel, and is characterized in that it includes an interruption component that is suited to interrupt electrical continuity and is connected in series to each one of said avalanche photodiodes. All of said interruption components belonging to the plurality of light sensitive microcells are configured so as to simultaneously switch over from a state of conduction to a state of inhibition or vice versa.

Further characteristics of the photomultiplier device of the invention are described in the dependent claims.

The invention also includes the method for controlling the photomultiplier device of the invention, according to claim 11.

Advantageously, the fact that each one of said interruption components is implemented through a reset MOS transistor in the manner described in claim 5 makes it possible to limit the space occupied by the same transistor within each light sensitive microcell and, consequently, to increase the Fill Factor value of the entire photomultiplier device.

Still advantageously, the fact of making a MOS capacitor for the extraction of the analog signal according to claim 6 allows the output signal to be made independent of the reset MOS transistor switchover control and also to effectively insulate the light sensitive microcells from one another and from the drain terminal of said reset transistor, as explained in detail in the description of the preferred embodiments of the photomultiplier device of the invention. Furthermore, another advantage, due to the particular implementation of a set of adjacent light sensitive microcells according to the characteristics described in claim 9 or 10, makes it possible to further limit the size of each individual light sensitive microcell and, consequently, to increase the Fill Factor value of the entire photomultiplier device of the invention.

Finally, to advantage, the photomultiplier device of the invention makes it possible to connect the sensitive surface to different types of logic units depending on the use requirements.

Consequently, a further advantage lies in the possibility to make the photomultiplier device of the invention in such a way that it can be modulated obtaining different functional efficiency levels, thus determining different production and selling costs.

The objects and advantages described above will be highlighted in greater detail in the description of two preferred embodiments of the invention provided by way of non-limiting example with reference to the attached drawings, wherein:
- Figure 1 shows an axonometric view of the photomultiplier device of the invention according to a first preferred embodiment;
- Figure 2 shows the circuit diagram of a single light sensitive microcell belonging to the photomultiplier device of the invention, in the state of inhibition of the interruption component;
- Figure 3 shows the circuit diagram of a single light sensitive microcell belonging to the photomultiplier device of the invention, in the state of conduction of the interruption component;
- Figure 4 shows the circuit diagram of a single light sensitive microcell according to an alternative embodiment to that shown in Figures 2 and 3, in the state of inhibition of the interruption component;
- Figure 5 shows the circuit diagram related to the implementation of the single microcell represented in Figures 2 and 3 according to a first preferred embodiment of the invention;
- Figure 6 shows a sectional view of the light sensitive microcell of Figure 5;
- Figure 7 shows a topographic view of a set of four light sensitive microcells according to the first preferred embodiment of the photomultiplier device of the invention;
- Figure 8 shows an axonometric view of the photomultiplier device according to a second preferred embodiment of the invention;
- Figure 9 shows the circuit diagram related to the implementation of a single light sensitive microcell according to said second preferred embodiment of the photomultiplier device of the invention shown in Figure 8;
- Figure 10 shows a topographic view of a set of four microcells according to said second preferred embodiment of the photomultiplier device of the invention shown in Figure 8;
- Figure 11 shows a topographic view of a set of light sensitive microcells of the photomultiplier device of the invention connected to one another in such a way as to allow the reading of the rows/columns of the single light sensitive microcells;
- Figure 12 shows a sectional view of a possible implementation of the light sensitive microcell schematically shown in Figure 4;
- Figure 13 shows the circuit diagram relating to the implementation of a single light sensitive microcell comprising two reset MOS transistors in series and a reset capacitor.

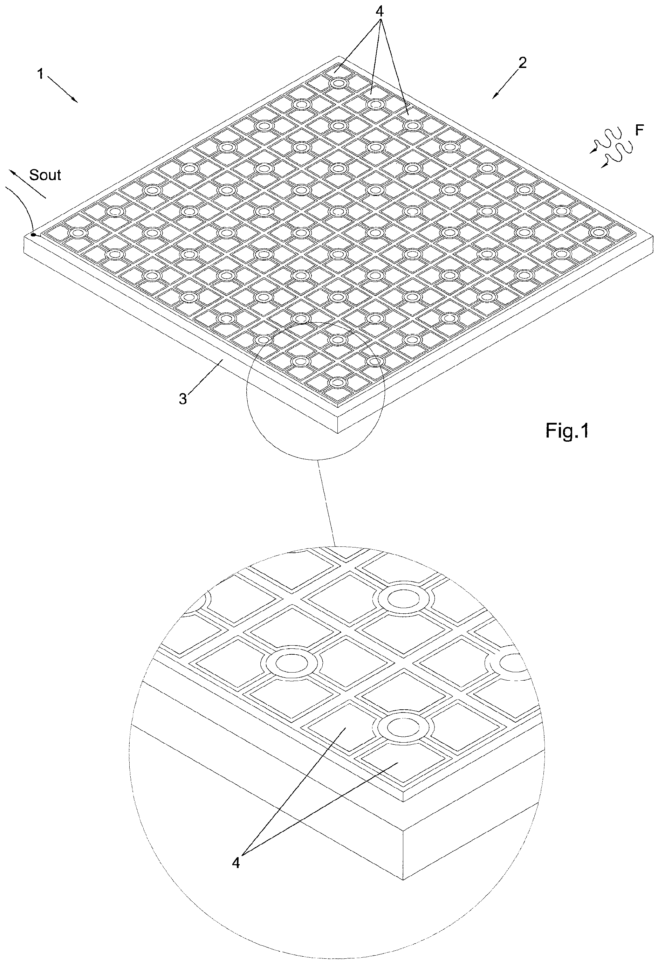

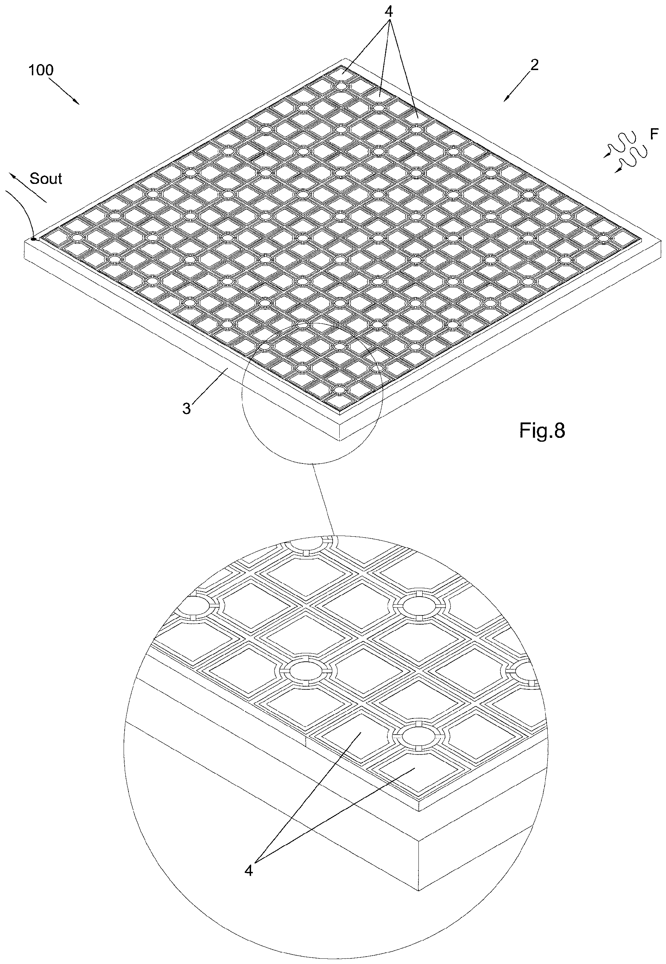

The solid-state photomultiplier device or SiPM for detecting one or more photons that is the subject of the invention is represented as a whole, according to a first preferred embodiment, in Figure 1, where it is indicated by **1** and, according to a second preferred embodiment, in Figure 8, where it is indicated by **100.**

Concerning the first preferred embodiment, as shown in Figure 1, the photomultiplier device **1** of the invention comprises a surface **2** that is sensitive to said photons **F** and created on a semiconductor substrate **3.** Said sensitive surface **2** is defined by a plurality of light sensitive microcells **4** connected to one another in parallel in such a way as to supply a single common analog output signal **Sₒᵤₜ** from the photomultiplier device **1.** For this reason, the photomultiplier device **1** of the invention is considered a solid-state photomultiplier device of the analog type.

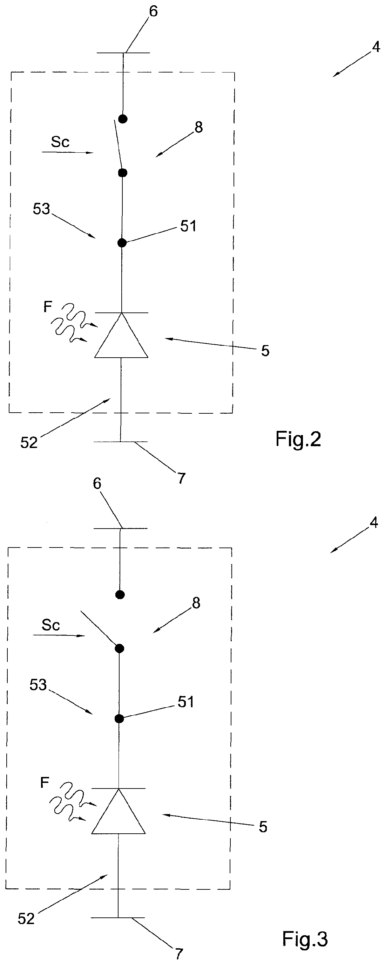

As can be observed in the circuit diagrams of Figures 2 and 3, each one of the light sensitive microcells **4** comprises an avalanche photodiode **5** interposed between a first electrode **6** and a second electrode **7,** which are configured so as to supply said avalanche photodiode **5** with a reverse polarization voltage. Said polarization voltage, in particular, is higher than the breakdown voltage **V_{BD}** of the avalanche photodiode **5** by a pre-defined value **V_{OV}.**

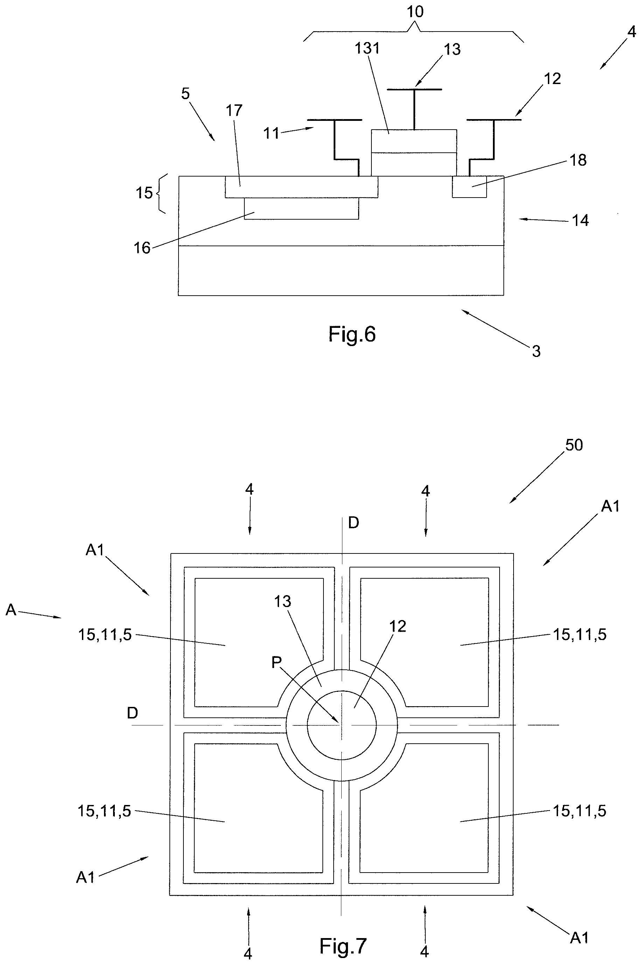

According to the preferred embodiment of the photomultiplier device **1** of the invention described herein and illustrated in Figure 6, the avalanche photodiode **5** is carried out with *n* on *p* technology, according to which the accumulation terminal **53** that accumulates the charge of the avalanche coincides with the cathode **51** of the same avalanche photodiode **5.** It cannot be excluded, however, that in an alternative embodiment of the photomultiplier device **1** of the invention the avalanche photodiode **5** may be made with *p* on *n* technology, according to which the accumulation terminal **53** that accumulates the charge of the avalanche coincides, instead, with the anode **52** of the same avalanche photodiode **5.** For this reason and for the sake of clarity, from this point onward, where not expressly specified otherwise the generic term accumulation terminal **53** will be used to indicate the cathode **51** of the *n* on *p* photodiode and the anode **52** of the *p* on *n* photodiode.

According to the invention, each one of said light sensitive microcells **4** comprises, furthermore, an interruption component **8** intended to interrupt electric continuity and interposed between the accumulation terminal **53** of the corresponding avalanche photodiode **5** and said first electrode **6.** All of said interruption components **8** of the plurality of light sensitive microcells **4** are configured in such a way as to simultaneously switch over from a state of conduction, schematically illustrated in Figure 2, to a state of inhibition, illustrated in Figure 3. Clearly, said interruption components **8** are configured also to be simultaneously switched over from said state of inhibition to the state of conduction.

In particular, said simultaneous switching operations of the interruption components **8** are carried out, as explained in detail here below in the description of the preferred embodiment of the photomultiplier device **1** of the invention, by means of a control signal **S_{c}** properly generated and sent to the same interruption components **8** as an input signal.

Advantageously, this type of implementation makes it possible to provide a method for the control and operation of the same photomultiplier device **1** according to an approach of the so-called "Passive Quenching - Active Recharge" or PQAR type. In other words, said control and operation method for controlling and operating the photomultiplier device **1** of the invention allows the passive quenching of the avalanche effect generated in one or more of the avalanche photodiodes **5** belonging to the various light sensitive microcells **4** and, at the same time, makes it possible to recharge the same light sensitive microcells **4,** and thus to reversely polarize said photodiodes **5,** in a desired time instant, meaning in an active mode (Active Recharge).

Advantageously, according to this embodiment of the invention, the exploitation of said interruption components **8** also as passive quenching circuits makes it possible to avoid the need to provide quenching resistors connected in series to the photodiodes **5,** and thus also makes it possible to reduce the production costs of the photomultiplier device **1.**

In order to better understand how this approach can be applied using the photomultiplier device **1** of the invention, the initial situation should be considered, in which all of the avalanche photodiodes **5** of the light sensitive microcells **4** are in a state of reverse polarization, meaning charged and ready to detect the absorption of a photon **F.** At the same time, the interruption components **8** should be considered as being in the state of inhibition, as shown in Figure 3. In this situation, following the impact of a photon **F** on one or more of said avalanche photodiodes **5,** said avalanche effect takes place in said photodiodes **5.** This avalanche effect is quenched in a passive manner, following the discharge of the junction capacitance of the avalanche photodiode **5** until reaching voltage **V_{BD},** as the interruption components **8,** being in the state of inhibition, substantially behave as an open circuit and do not allow the current flow through the light sensitive microcell. In this condition, the single light sensitive microcells **4** in which the avalanche effect was generated and quenched remain inhibited until the same interruption components **8** are switched over to the state of conduction, that is, until the corresponding avalanche photodiodes **5** are once again polarized reversely until reaching voltage **V_{BD}+V_{OV}.**

Once the simultaneous switching over of all the interruption components **8** to the state of conduction has been activated, said light sensitive microcells **4** on which said avalanche effect has occurred are recharged and return to an active state, like the other light sensitive microcells **4** on which no photon **F** has impacted and, consequently, on which said avalanche has not occurred. Therefore, the entire sensitive surface **2** of the photomultiplier device **1** is again in an active state, ready to detect the impact of one or more photons **F** on it. At this point, all of the interruption components **8** are again simultaneously switched over to the state of inhibition in order to re-establish said initial condition.

Said simultaneous double switching over of the interruption components **8,** which from this point onwards will be referred to as "reset phase", is repeated every time interval **T,** whose value is properly selected based on the electrical characteristics and the use requirements of the photomultiplier device **1.** In practice, all of the light sensitive microcells **4** are theoretically in an active state, meaning that they are capable of detecting a photon **F** that impacts their sensitive part, for a period of time that elapses between a reset phase and the successive one.

This type of approach implemented by means of the photomultiplier device **1** of the invention makes it possible to obtain a series of advantageous technical effects that in turn allow the above mentioned objects of the invention to be achieved.

In particular, a first advantageous effect that is obtained through the implementation of said reset phase on the photomultiplier device **1** of the invention lies in that the light sensitive microcells **4** with a high level of DCR tend, immediately after each reset phase, to generate an avalanche effect independently of whether photons **F** impact them or not. Therefore, these light sensitive microcells **4** do not contribute to the DCR of the photomultiplier device **1** for most of the time during which the same device **1** is sensitive to photons, that is, between a reset phase and the successive one.

At this point, it is important to underline that, in general, in the population of light sensitive microcells **4** of a SiPM, it is common that a small portion of said microcells contributes to most of the DCR.

As already explained, for the reasons described above, the avalanche effects generated in said light sensitive microcells **4** with a high level of DCR tend to be exhausted in a limited time. This effect, even if it involves the loss of part of the sensitive surface of the photomultiplier device **1** due to the quenching of said light sensitive microcells **4,** limits the contribution of these latter light sensitive microcells **4** to the total noise of the same photomultiplier device **1** to a small fraction of the period during which the sensitive surface is in the active state. Therefore, to advantage, once said very noisy light sensitive microcells **4** have been quenched, a fair comprise is obtained between the efficiency (intended as "Photo Detection Efficiency" or PDE) of the photomultiplier device **1,** which decreases, and the noisiness of the same device.

Advantageously, in this way an effect is automatically produced that is similar to the programmable quenching of the more noisy light sensitive microcells in a photomultiplier device of the digital type.

Moreover, a further advantageous effect that is obtained with the use of the photomultiplier device **1** of the invention is the considerable reduction, if not the elimination, of the phenomenon of "Afterpulsing". In fact, as following the generation of the avalanche effect in a single light sensitive microcell **4** this microcell remains inhibited until the successive reset phase, by selecting a suitable reset interval **T** it is possible to inhibit a further generation of avalanche effect on the same light sensitive microcell **4** due to the phenomenon of Afterpulsing. From this point of view, the resulting effect is very similar to the effect obtained with an active quenching circuit, as described above. Even for this reason, advantageously, a fair compromise is obtained between the efficiency of the photomultiplier device **1** of the invention and the noise level of the same.

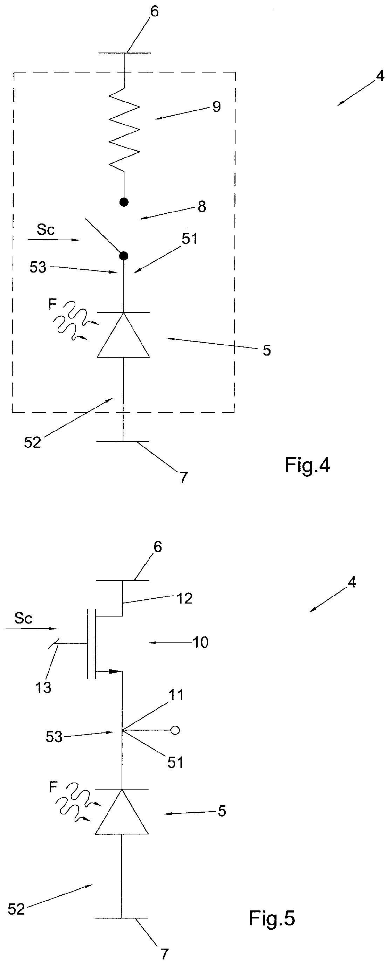

According to the preferred embodiment of the photomultiplier device **1** of the invention, the first and the second electrode **6** and **7** are shared by the plurality of light sensitive microcells **4,** in such a way as to provide the corresponding avalanche photodiodes **5** with a common reverse polarization voltage. Furthermore, according to the preferred embodiment of the invention, each one of said interruption components **8,** as can be observed in Figure 5, is a reset MOS transistor **10** connected, by means of its source terminal **11,** to the accumulation terminal **53** of the avalanche photodiode **5,** which in the case at hand corresponds to the cathode **51** of the same photodiode **5,** and to the first electrode **6** by means of its drain terminal **12.** Furthermore, all of the reset MOS transistors **10** of the plurality of light sensitive microcells **4** have their gate terminals **13** connected together. Said gate terminals **13,** furthermore, are configured in such a way as to receive said impulse control signal **S_{c}** as an input, so as to control the simultaneous switching over of the same reset MOS transistors **10** from said state of conduction to the state of inhibition and vice versa and, consequently, in such a way as to carry out the reset phase described above.

According to an alternative embodiment of the light sensitive microcells **4** described herein and illustrated in Figures 2 and 3, a quenching component **9** can be interposed between the interruption component **8** and the first electrode **6,** as can be observed in Figure 4. The presence of said quenching component **9,** advantageously, makes it possible to quench any avalanche effect that may be generated in the light sensitive microcells **4** during the reset phase, meaning when the interruption component **8** is in the state of conduction and therefore cannot stop this phenomenon.

Preferably but not necessarily, said quenching component **9** is implemented through a quenching resistor **9.**

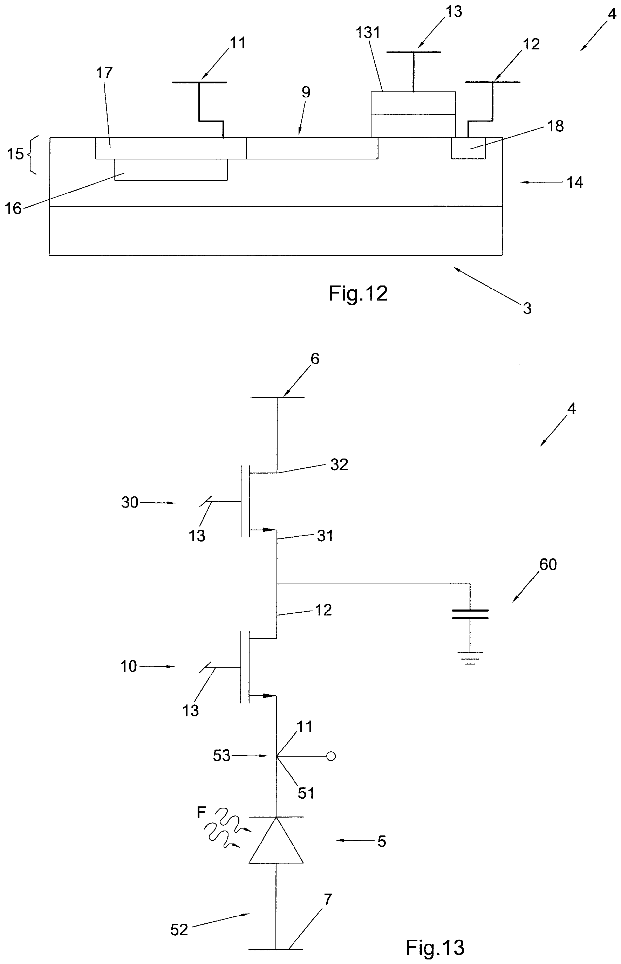

Furthermore, according to a preferred embodiment of the invention, said quenching resistor **9** is made of silicon, with a layer of the same type as that of the surface layers n+ (or p+), and subjected to suitable doping to obtain the desired resistance value. In this way the quenching resistor **9** can be carried out as a single piece with the layer corresponding to the source terminal **11** of the reset MOS transistor **10** or replace it, as shown in Figure 12, or, according to a further variant embodiment, replace the layer corresponding to the drain terminal **12.** Advantageously, in this manner the quenching resistor **9** is made with a single additional layer and with just one additional lithographic mask with respect to the standard process according to which only the reset MOS transistor **10** is provided.

It cannot be excluded that in different embodiments of the photomultiplier device **1** of the invention said quenching component **9** can be implemented in another way, different from a quenching resistor, provided that it is capable of quenching any avalanche effect that may occur during said reset phase.

In this regard, it is important to highlight that which happens in a photodiode **5** when, during a reset phase of the photomultiplier device **1,** an avalanche occurs. In this situation, the number of carriers that pass through the junction of the photodiode **5** during the avalanche - also called the "gain" of the avalanche - is much higher compared to "normal" events, considering that the avalanche current is not stopped by the quenching effect.

Consequently, also the number of photons **F** emitted by the hot carriers and the probability of occurrence of Optical Crosstalk among the light sensitive microcells **4** is proportionally higher. Therefore, if an avalanche occurs in a light sensitive microcell **4** during the reset phase, it is highly probable that other avalanches will occur also in the adjacent light sensitive microcells **4** and generate further avalanches, until all of the light sensitive microcells **4** of the photomultiplier device **1** are affected.

The result of this process is that the entire photomultiplier device **1** is not sensitive to light until the beginning of the successive reset phase. The probability that this will occur depends, in a first approximation, on the DCR, on the duration of the reset phase, on the reset interval **T** and on the overvoltage. Therefore, the presence of said quenching component **9,** and in particular of the quenching resistor **9,** advantageously makes it possible to avoid said concatenation of effects.

In practice, according to the preferred embodiment of the invention described herein, in the photomultiplier device **1** the light sensitive microcells **4** are provided on said single semiconductor substrate **3.** In particular, preferably but not necessarily, said semiconductor substrate **3** comprises an epitaxial substrate **14** superimposed to a highly doped layer.

As can be observed in Figure 6, in the preferred embodiment of the photomultiplier device **1** the p-n junction **15** of the avalanche photodiode **5** is defined on said semiconductor substrate **3** for each light sensitive microcell **4,** said junction, as explained above, being carried out according to *n* on *p* technology.

Always according to said first preferred embodiment of the invention, said p-n junction **15** features, in particular, a first layer **16** subjected to doping of type p+, above which a second layer **17** is defined that is subjected to doping of type n+. In particular, said second layer **17** serves both as cathode **51,** and therefore as accumulation terminal **53,** of the avalanche photodiode **5,** and as source terminal **11** of the reset MOS transistor **10.** A third layer **18** is furthermore defined on the semiconductor substrate **3,** said third layer being spaced from said p-n junction **15** and subjected to doping of type n+, meaning the same type of doping of said second layer **17,** in such a way as to define the drain terminal **12** of the rest MOS transistor **10.**

As explained above, it cannot however be excluded that in an alternative embodiment of the photomultiplier device **1** of the invention, the p-n junction **15** of the avalanche photodiode **5** may be made with *p* on *n* technology. In this case, the first layer **16** is subjected to doping of type n+, while said second and third layers **17** and **18** are subjected to doping of type p+.

Concerning the gate terminal **13** of the rest MOS transistor **10,** as can be observed in Figure 6 this is superimposed to the semiconductor substrate **3** between the p-n junction **15** and the third substrate **18.** Said gate terminal **13** preferably comprises a metal layer **131.**

Advantageously, this solution makes it possible to obtain the avalanche photodiode **5** and the reset MOS transistor **10** of each one of the light sensitive microcells **4** occupying a smaller area of the surface of the photomultiplier device **1** compared to the area that would be occupied by a photodiode and a separate MOS transistor. Therefore, this embodiment of the single light sensitive microcell **4** shown in Figure 6 makes it possible to maintain a high Fill Factor value for the entire photomultiplier device **1,** notwithstanding the introduction of an active component, like the reset MOS transistor **10.**

Furthermore, according to the preferred embodiment of the invention described herein and represented in Figure 6, the source terminal **11** and the drain terminal **12** of the reset MOS transistor **10** are preferably but not necessarily carried out substantially exploiting the same layer n+ that allows the accumulation terminal **53** of the avalanche photodiode **5** to be defined. Therefore, this implementation, advantageously, does not increase the complexity of the process required to make said light sensitive microcell **4.**

At this point of the description it is important to underline that the structure of the single light sensitive microcell **4** shown in Figure 6 makes it possible to obtain advantages that are independent of the overall structure and the specific operation of the photomultiplier device **1** of the invention described above. Therefore, said characteristics of the light sensitive microcell **4** that have just been described above may even be claimed, independently of said overall structure of the photomultiplier device **1** that is the object of the present invention and of the related control and operation method.

Furthermore, in order to maintain a high Fill Factor value for the photomultiplier device **1** of the invention, the latter comprises a plurality of sets of light sensitive microcells **50** located side by side, wherein each one of said sets **50,** as shown in Figure 7, comprises four of said light sensitive microcells **4.** In particular, the four light sensitive microcells **4** that make up each one of said four sets **50,** according to the topographic view of Figure 7, are grouped inside a quadrangular area **A.** In greater detail, in said quadrangular area **A** it is possible to identify the p-n junctions **15** of the four light sensitive microcells **4,** carried out so that they are adjacent in pairs at the level of the sectors **A1** defined by the intersection of two axes **D** passing through the same quadrangular area **A.** As already explained above, each p-n junction **15** defines the avalanche photodiode **5** and the source terminal **11** of the reset MOS transistor **10** of one of the four light sensitive microcells **4.** As can be observed always in Figure 7, the drain terminals **12** of the reset MOS transistors **10** are carried out as a single element defined in the point **P** of intersection of the two axes **D.**

Furthermore, according to the preferred embodiment of the invention described herein, the gate terminals **13** of the reset MOS transistors **10** are connected together and are superimposed to said semiconductor substrate **3** between the common drain terminal **12** and the source terminal **11.** Finally, preferably but not necessarily, the photomultiplier device **1** of the invention comprises electric insulation elements provided along the axes **D** and on the perimeter of the quadrangular area **A,** in such a way as to electrically insulate from one another the p-n junctions **15** of the adjacent light sensitive microcells **4.**

Also in this case, the advantages obtained thanks to this special structure of the set **50** comprising four light sensitive microcells **4** are independent of the overall structure and the specific operation of the photomultiplier device **1** of the invention described above. Therefore, also in this case, said characteristics of the set **50** may even be the subject of a claim, independently of the overall structure of the photomultiplier device **1** that is the subject of the present invention and of the related control and operation method.

According to the preferred embodiment of the photomultiplier device **1** described herein, the reading of the analog output signal **Sₒᵤₜ** generated by the photomultiplier device **1** of the invention is carried out by means of the AC coupling technique through the gate terminals **13** of the reset MOS transistors **10,** which are connected together, or through the Back of the same photomultiplier device **1.**

Advantageously, the extraction of the signal **Sₒᵤₜ** by means of said AC coupling technique allows the signal to be read rapidly ("fast timing"), given that the latter has a wave shape that is substantially equal to the derivative of a step signal and therefore very short and without undershoot.

Alternatively, said reading may also be made in DC through the drain terminals **12,** always of the reset MOS transistors **10** belonging to the photomultiplier device **1** of the invention.

In this way, the information on the light sensitive microcells **4** that switched over during the reset interval **T** is maintained in the photomultiplier device **1** until the beginning of the successive reset cycle, when it is read.

A possible further application of this method for storing the signal and reading the same in DC relates to the reading of the rows/columns of the single light sensitive microcells **4** or of subsets of microcells of the photomultiplier device **1.**

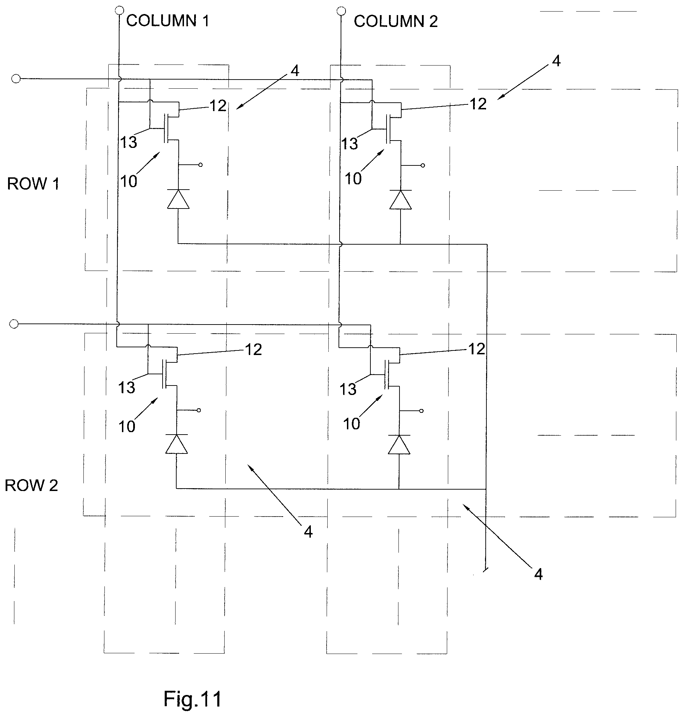

A typical subdivision may lead to the division of the active area of the photomultiplier device **1** into a grid of smaller sub-SiPMs. As can be observed in Figure 11, the drain terminals **12** of the reset MOS transistors **10** of the microcells **4** of each column of sub-SiPMs are connected together, like the gate terminals **13** of each row of the sub-SiPM. In the instant when the reading in DC is performed, at the end of the reset interval **T,** the various gate terminals **13** are enabled in sequence, so that the charge stored in the sub-SiPM corresponding to the gate terminal **13** enabled in that precise moment and to the related drain terminal **12** exits from each column constituted by the drain terminals **12** connected together. Each drain terminal **12** is associated with a separate reading channel. In this way, to advantage, only *n* reading channels are needed to read an array of *n* x *n* sub-SiPMs. Alternatively, a further method for reading rows/columns may include the connection of all of the drain terminals **12** together to a single reading channel. According to this method, therefore, two MOS transistors in series are used for each light sensitive microcell **4,** as can be observed in Figure 13, said MOS transistors being connected to two control gate terminals **13** that are distinct from each other. The two control gate terminals **13** are respectively connected by rows and by columns, obtaining the effect that the rows/columns are read from the drain terminals **12** with a single reading channel, but requiring more time (*n* x *n* x Tread, where Tread is the time needed to read/reset a sub-SiPM).

It cannot be excluded, furthermore, that the reading of rows/columns of the individual light sensitive microcells **4,** carried out by means of the photomultiplier device **1** of the invention, may be implemented in a way different from those described above.

As previously explained, a second embodiment of the photomultiplier device 1 of the invention is shown in Figure 8, where it is indicated by **100.**

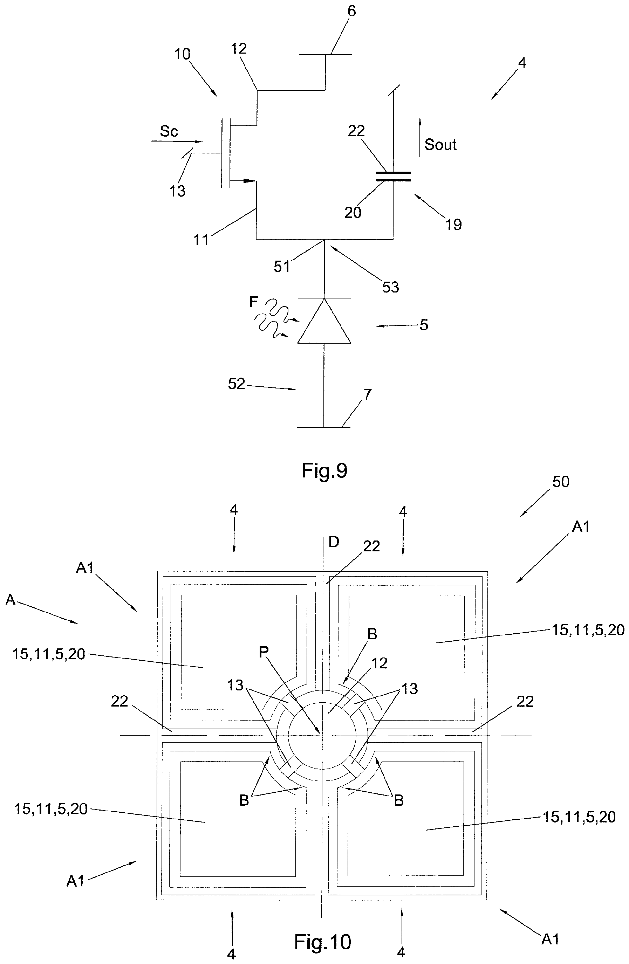

Said photomultiplier device **100** is distinguished from the first embodiment of the invention described above due to the fact that each individual light sensitive microcell **4,** as shown in Figure 9, comprises also an extraction capacitor **19** coupled with the corresponding avalanche photodiode **5** and configured in such a way as to allow the reading, from a first terminal of its own, of the output signal **Sₒᵤₜ** through said AC coupling technique. This solution, advantageously, makes it possible to simplify the reading operations, considerably reducing any interference between the impulse control signal **S_{c}** and said output signal **Sₒᵤₜ.**

Preferably, according to said second embodiment of the device **100** of the invention, said extraction capacitor **19** is made with MOS technology, so that said reading terminal corresponds to the plate of said capacitor **19** constituted by the so-called conductor side **22** of the MOS, while the second plate of the extraction MOS capacitor **19** is defined by the semiconductor side **20.** Preferably, the conductor side **22** is made of a metallic material. It cannot be excluded, however, that said conductor side **22** be made, for example, in polysilicon or any other material, provided that it is a conductor material.

In even greater detail, the conductor side **22** of the extraction MOS capacitor **19** is electrically insulated from the gate terminal **13** of the reset MOS transistor **10.**

Furthermore, the semiconductor side **20** of the extraction MOS capacitor **19** corresponds to the accumulation terminal **53** of the photodiode **5,** and thus to the source terminal **11** of the reset MOS transistor **10.**

Following this approach it is possible to make a relatively small reset MOS transistor **10,** to induce a reduced disturbance, and a large extraction MOS capacitor **19,** in order to collect the signal **Sₒᵤₜ** as effectively as possible. Optionally, in order to reduce the number of connections towards the outside of the photomultiplier device **100,** the conductor side **22** of the extraction MOS capacitor **19** and the drain terminal **12** of the reset MOS transistor **10** can be connected together. In fact, the signal **Sₒᵤₜ** in AC travels through the extraction MOS capacitor **19** when the reset is not active, while the reset control signal **S_{c}** travels in the drain terminal **12** during the reset cycle, and therefore the two signals **Sₒᵤₜ** and **S_{c}** are temporally separated.

Furthermore, in said second embodiment of the photomultiplier device **100** of the invention, in each one of said light sensitive microcells **4** the conductor side **22** of the extraction MOS capacitor **19** is created, as is clearly explained below, along the boundary lines between the same light sensitive microcell **4** and the adjacent light sensitive microcell **4.**

This last characteristic of the photomultiplier device **100** of the invention makes it possible to exploit the conductor side **22** also or exclusively in the case in which the reading of the signal **Sₒᵤₜ** is not carried out through said conductor side **22,** as an electric insulation element between two adjacent light sensitive microcells **4.**

In particular, in the case where the MOS capacitor **19** is used exclusively to obtain electric insulation between the various adjacent light sensitive microcells **4** and between each one of them and the drain terminal **12** of the MOS transistor **10,** the semiconductor side **20** of the same MOS capacitor **19** may correspond, as an alternative to said source terminal **11** of said MOS transistor **10,** to said drain terminal **12.**

In both cases, to obtain said insulation, the MOS capacitor **19** is properly polarized in DC, in such a way as to modify the potential of silicon between the doped layers on which the conductor side **22** is made.

Advantageously, in the case of the preferred embodiment described herein, according to which the p-n junctions **15** of the avalanche photodiode **5** are made with *n* on *p* technology, said implementation of insulation among light sensitive microcells **4** is more efficient from the point of view of the space occupied compared, for example, to the known technique that in technical jargon is called "p-stop". By the way, in the alternative case in which said p-n junctions **15** were made with *p* on *n* technology, said known technique would be of the "n-stop" type. Concerning, again, the implementation of insulation by means of said MOS capacitor **19,** this is more economic than the above mentioned "p-stop" or "n-stop" techniques.

As in the case of the photomultiplier device **1** of the first preferred embodiment of the invention, in order to maintain a high Fill Factor value and at the same time obtain all of the advantages described up to now, also the photomultiplier device **100** of the invention preferably but not necessarily comprises a plurality of adjacent sets **50** of light sensitive microcells **4.** In particular, each one of said sets **50,** as can be observed in the topographic view shown in Figure 10, comprises four light sensitive microcells **4** grouped inside a quadrangular area **A.** In said quadrangular area **A** it is possible to identify the p-n junctions **15** of the four light sensitive microcells **4** adjacent in pairs at the level of the sectors **A1** defined by the intersection of two axes **D** passing through the same quadrangular area **A.** Each one of the p-n junctions **15,** as already explained above, defines the avalanche photodiode **5,** the source terminals **11** of the reset MOS transistor **10** and the semiconductor side **20** of the extraction MOS capacitor **19** of one of the light sensitive microcells **4.** Furthermore, also in this case the drain terminals **12** of the reset MOS transistors **10** are made as a single element defined in the point **P** of intersection of said two axes **D.** Furthermore, as can be observed always in Figure 10, the conductor side **22** of the extraction MOS capacitor **19** of each one of the light sensitive microcells **4** is shared by the adjacent light sensitive microcell **4** along the portion of each axis **D** interposed between the corresponding two p-n junctions **15.**

This implementation, as explained above, advantageously makes it possible to use said MOS capacitor **19** to insulate the adjacent light sensitive microcells **4** and, furthermore, to insulate each one of them and the drain terminal **12** of the reset MOS transistor **10** in the areas, indicated by **B** in Figure 10, in which the gate terminal **13** of the same reset transistor **10** is not present between the avalanche photodiode **5** of the light sensitive microcell **4** and said drain terminal **12.** In order to obtain said insulation, the MOS capacitor **19** is properly polarized in DC, in such a way as to modify the potential of silicon among the doped layers on which the conductor side **22** is made.

In the same way, the gate terminal **13** of the reset MOS transistor **10** of each one of the light sensitive microcells **4** is made in the space defined within the sector **A1** of the corresponding p-n junction **15** between the adjacent and intersecting portions of the two axes **D.** Furthermore, each one of said gate terminals **13** is superimposed to said semiconductor substrate **3** between the drain terminal **12** and the source terminal **11** of the light sensitive microcell **4.** Once again it is important to underline that the advantages obtained thanks to said special structure of the set **50** comprising four light sensitive microcells **4** are independent of the overall structure and of the specific operation of the photomultiplier device **100** of the invention described above. Therefore, also in this case, these characteristics of the set **50** may even be claimed, independently of the overall structure of the photomultiplier device **100** that is the subject of the present invention and of the related control and operation method.

As already explained, the invention also includes the method for controlling the photomultiplier devices **1** and **100** of the invention, both provided with an interruption component **8** connected in series to the avalanche photodiode **5** of each one of the light sensitive microcells **4.** The control method, according to the invention, controls the simultaneous switching over of said interruption components **8** of the plurality of light sensitive microcells **4** from the state of inhibition to the state of conduction, in such a way as to impose the desired reverse polarization voltage between the cathode **51** and the anode **52** of each one of the avalanche photodiodes **5.** Furthermore, in sequence, the method that is the subject of the invention controls the simultaneous switchover of the interruption components **8** of said plurality of light sensitive microcells **4** from the state of conduction to the state of inhibition, in such a way as to electrically insulate each one of the avalanche photodiodes **5** from the first electrode **6.** In this condition of reverse polarization, the avalanche photodiodes **5,** as described above, are configured to generate an avalanche current in the case where one or more photons **F** impact on them. According to the method of the invention, said two switching over operations carried out in sequence, previously defined also as reset phases, are repeated at pre-defined time intervals **T,** whose duration is properly selected based on the electrical characteristics and use requirements of the photomultiplier device **1** and **100.** In particular, according to the control method of the invention, said reset phase is carried out through the application of an impulse control input signal **S_{c}** lasting for a time interval **T** to the gate terminals **13,** connected together, of the reset MOS transistors **10** of the photomultiplier device 1 and **100** of the invention.

In greater detail, the switching over from the state of inhibition to the state of conduction is carried out at the level of the rising edge of the impulse of the impulse control signal **S_{c},** while the switching over of the reset MOS transistors **10** from the state of conduction to the state of inhibition is carried out at the level of the falling edge of the same impulse.

Considering the phenomenon of the avalanches that occur during the reset phase, as described above, a method for reducing its effect on the photomultiplier device **1** and **100** consists in dividing the reset cycle, defined as the time interval during which the interruption components **8** are in the state of conduction, into two or more shorter sub-cycles to be rapidly carried out in sequence, in such a way as to cover the same duration of the reset cycle. The minimum value of the entire duration of the reset cycle is selected in advance, in order to obtain a complete recharge of the avalanche photodiodes **5.** In this way, if an avalanche occurs in one or more avalanche photodiodes **5** during a reset sub-cycle, this is advantageously quenched at the end of the same sub-cycle and not at the end of the entire reset cycle. Therefore, the average duration of the avalanches that occur during the reset phase is advantageously reduced and consequently also the average number of photons **F** emitted for each one of them is reduced. Consequently, the probability that said negative phenomenon may end with inhibiting the entire photomultiplier device **1** and **100,** making it insensitive to the photons **F** during the successive reset interval **T,** is reduced to the same extent.

An alternative method for reducing the effect of the avalanches that occur during the reset phase consists in adding, to each light sensitive microcell **4,** a second interruption component **30,** as can be observed in Figure 13, between the first interruption component **8,** represented in Figures 2 and 3, and the first electrode **6,** as well as a capacitor **60** connected with a first plate of its own between said two interruption components **8** and **30.** In this configuration, the reset phase takes places as described here below. At the beginning the interruption components **8** and **30** are in the state of inhibition. Successively, the interruption component **30** is switched over from the state of inhibition to the state of conduction, charging the capacitor **60** at the reset voltage, which corresponds to the polarization to be imposed to the accumulation terminal **53** of the photodiode **5.** In a successive stage the interruption component **30** is switched over to the state of inhibition again and the interruption component **8** is switched over to the state of conduction, so that the charge stored in the capacitor **60** is transferred to the accumulation terminal **53,** restoring the above mentioned polarization voltage. During the time interval **T** between a reset cycle and the successive one, the interruption component **30** can remain in the state of conduction, maintaining the capacitor **60** charged at the reset voltage. In this way, said capacitor **60** is already charged at the beginning of the successive reset cycle. Depending on the value of the capacitor **60,** a single reset cycle may not be sufficient to recharge the accumulation terminal **53** at a voltage that is sufficiently near to the desired one. In this case, it is possible to repeat an *n* number of sequential reset sub-cycles, until obtaining the desired charge of the accumulation terminal **53.** With said implementation illustrated in Figure 13, in the case where an avalanche should occur while the interruption component **8** is in the state of conduction, the same avalanche would be quenched in any case, as the interruption component **30** is in the state of inhibition. The gain is higher than that of a "normal" event, as the avalanche discharges the capacitor **60** beyond the capacity of the photodiode **5,** but in general it is much lower than the gain that would result if the avalanche taking place during the reset phase were not quenched.

As can be observed always in Figure 13, according to a possible implementation of the circuit, both the interruption components **8** and **30** are made with MOS transistors **10** and **30** implemented in the same way as the single reset MOS transistor **10** shown in Figure 6. In particular, it is possible to use the same layer n+ of the photodiode **5** to implement also the source terminals **11** and **31** and the drain terminals **12** and **32** of said two MOS transistors **10** and **30.** In the case of the double reset transistor, the source terminal **11** related to the MOS transistor **10** is melted with the accumulation terminal **53** of the photodiode **5,** while the drain terminal **12** of the same MOS transistor **10** is melted with the source terminal **31** of the MOS transistor **30,** advantageously obtaining a very compact and efficient structure in terms of area consumption. The capacitor **60** can simply be the capacity of the source terminal **31** of the MOS transistor **30** and of the drain terminal **12** of the MOS transistor **10** to earth.

The capacitor **60** and the MOS transistor **30** can also be shared by sets of microcells **4,** for the purpose of saving more active area and obtain higher values for the capacitor **60,** which allow a more complete reset of the photodiode **5** for each reset sub-cycle. Furthermore, if the capacitor **60** is shared among several microcells **4** of the same set, those microcells **4** in which no avalanche occurred in the previous reset interval **T** are already polarized at the reset voltage and the capacity of their photodiodes **5** contributes, in parallel to the capacitor **60,** to recharging the photodiodes **5** of the microcells **4** that on the contrary switched over in the previous reset interval.

Going back to the control method that is the subject of the invention, as already stated above, according to a first preferred embodiment of the invention it includes the extraction of the common output signal **Sₒᵤₜ** through the AC coupling technique on the gate terminal **13** of the reset MOS transistor **10** or from the Back of the photomultiplier device **1** and **100,** or, in the case of the photomultiplier device **100,** on the conductor side **22** of the extraction MOS capacitor **19.**

It cannot be excluded, however, that in the method of the invention the extraction of the common output signal **Sₒᵤₜ** is carried out through the DC reading technique from the drain terminal **12** of the reset MOS transistor **10.**

This last implementation would make it possible to read the charge, meaning the number of light sensitive microcells **4** in which an avalanche took place in the reset interval **T,** at the end of said interval **T,** according to the procedures previously described in detail.

According to the above, it can therefore be understood that the photomultiplier device of the invention and the related control method achieve all the set objects.

In particular, the invention achieves the object to provide a photomultiplier device of the analog type that following a recharge phase of the entire light sensitive surface is capable of automatically and rapidly inhibiting those light sensitive microcells that are considered highly noisy, that is, the microcells having a high "Dark Count Rate".

The invention also achieves the object to provide a photomultiplier device that is capable of limiting, if not eliminating, the so-called "Afterpulsing" phenomenon in the individual light sensitive microcells.

The invention achieves the further object to provide a photomultiplier device that, considering light sensitive microcells having the same size, makes it possible to increase the FF compared to the photomultiplier devices of the known art, or that makes it possible to reduce the size of the light sensitive microcells though maintaining a high FF value.

The invention also achieves the object to provide a photomultiplier device whose production efficiency is better than that of the photomultipliers of the known art, thanks to the fact that a smaller number of rejects is generated during production.

Finally, the invention achieves the object to provide a photomultiplier device of the analog type integrating those structural and functional characteristics, typical of digital photomultiplier devices, that make it possible to obtain the advantages defined above while at the same time maintaining a lower production cost compared to said digital devices.

## Claims

1. Solid-state photomultiplier device (SiPM) (1) for detecting one or more photons (F), of the type comprising a surface (2) sensitive to said photons (F) and created on a semiconductor substrate (3), said sensitive surface (2) being defined by a plurality of light sensitive microcells (4) connected to one another in parallel in such a way as to send out a common analog output signal (Sₒᵤₜ), each one of said light sensitive microcells (4) comprising an avalanche photodiode (5) interposed between a first electrode (6) and a second electrode (7) suited to supply said avalanche photodiode (5) with a reverse polarization voltage, **characterized in that** for each one of said light sensitive microcells (4) it comprises an interruption component (8) suited to interrupt electrical continuity and interposed between the accumulation terminal (53) that accumulates the avalanche charge of said avalanche photodiode (5) and said first electrode (6), said interruption components (8) of said plurality of light sensitive microcells (4) being configured so as to simultaneously switch over from a state of conduction to a state of inhibition or vice versa.

2. Photomultiplier device (1) according to claim 1, **characterized in that** for each one of said light sensitive microcells (4) it comprises a quenching component (9) interposed between said interruption component (8) and said first electrode (6).

3. Photomultiplier device (1) according to any of the preceding claims, **characterized in that** said first electrode (6) and said second electrode (7) are shared by said plurality of light sensitive microcells (4), in such a way as to supply said avalanche photodiodes (5) of said plurality of light sensitive microcells (4) with a common reverse polarization voltage.

4. Photomultiplier device (1) according to any of the preceding claims, **characterized in that** each one of said interruption components (8) is a reset MOS transistor (10) connected to said accumulation terminal (53) of said avalanche photodiode (5) with its source terminal (11) and to said first electrode (6) with its drain terminal (12), the gate terminals (13) of said reset MOS transistors (10) of said plurality of light sensitive microcells (4) being connected together and being configured to receive an impulse control input signal (S_{c}) for the simultaneous switchover of said reset MOS transistors (10) from said conduction state to said inhibition state or vice versa.

5. Photomultiplier device (1) according to claim 4, **characterized in that** each one of said light sensitive microcells (4) is created on said semiconductor substrate (3), the following being defined in said semiconductor substrate:
- the p-n junction (15) of said avalanche photodiode (5) defined by a first layer (16) subjected to a first doping type, p+ or n+, above which a second layer (17) is defined that is subjected to an opposite doping type, n+ or p+, with respect to said first layer (16), said second layer (17) serving both as accumulation terminal (53) of said avalanche photodiode (5) and as source terminal (11) of said reset MOS transistor (10);
- a third layer (18) carried out so that it is spaced from said p-n junction (15) and subjected to a doping type, n+ or p+, corresponding to said second layer (17) so as to serve as drain terminal (12) of said reset MOS transistor (10);
- the gate terminal (13) of said reset MOS transistors (10), carried out so that it is superimposed to said semiconductor substrate (3) between said p-n junction (15) and said third layer (18).

6. Photomultiplier device (1) according to claim 4 or 5, **characterized in that** each one of said light sensitive microcells (4) comprises an extraction MOS capacitor (19) coupled with said avalanche photodiode (5) and configured to allow the extraction of said output signal (Sₒᵤₜ) from its conductor side (22) through the AC coupling technique.

7. Photomultiplier device (1) according to claim 6, **characterized in that** for each one of said light sensitive microcells (4):
- the semiconductor side (20) of said extraction MOS capacitor (19) coincides with said source terminal (11) of said reset MOS transistor (10);
- said conductor side (22) of said extraction MOS capacitor (19) is electrically insulated from said gate terminal (13) of said reset MOS transistor (10).

8. Photomultiplier device (1) according to claim 7, **characterized in that** for each one of said light sensitive microcells (4):
- said conductor side (22) of said extraction MOS capacitor (19) is carried out along the boundary lines between said light sensitive microcell (4) and the adjacent light sensitive microcell (4) and/or between the p-n junctions (15) and the drain terminal (12) of the reset transistor (10) of each one of said light sensitive microcells (4) so as to serve as an electric insulation element.

9. Photomultiplier device (1) according to claim 4 or 5, **characterized in that** it comprises at least one set (50) comprising four of said light sensitive microcells (4) grouped together, according to a topographic view of said set (50), inside a quadrangular area (A) in which it is possible to identify:
- said p-n junctions (15) carried out so that they are adjacent in pairs at the level of the sectors (A1) defined by the intersection of two axes (D) passing inside said quadrangular area (A), each one of said p-n junctions (15) defining said avalanche photodiode (5) and said source terminal (11) of said reset MOS transistor (10) of one of said light sensitive microcells (4);
- said drain terminals (12) carried out as a single piece defined in the point (P) of intersection of said two axes (D);
- said gate terminals (13) connected together and superimposed to said semiconductor substrate (3) between said drain terminals (12) and said source terminals (11).

10. Photomultiplier device (1) according to any of the claims from 6 to 8, **characterized in that** it comprises at least one set (50) comprising four of said light sensitive microcells (4) grouped together, according to a topographic view of said set (50), inside a quadrangular area (A) in which it is possible to identify:
- said p-n junctions (15), carried out so that they are adjacent in pairs at the level of the sectors (A1) defined by the intersection of two axes (D) passing inside said quadrangular area (A), each one of said p-n junctions (15) defining said avalanche photodiode (5), said source terminal (11) of said reset MOS transistors (10) and said semiconductor side (20) of said extraction MOS capacitor (19) of one of said light sensitive microcells (4);
- said drain terminals (12) of said reset MOS transistors (10), created as single pieces defined in the point (P) of intersection of said two axes (D);
- said conductor side (22) of the extraction MOS capacitor (19) of each one of said light sensitive microcells (4), carried out in common with the adjacent light sensitive microcell (4) along the portion of axis (D) interposed between the two corresponding p-n junctions (15) and/or between each one of said p-n junctions (15) and said drain terminal (12) of said reset transistor (10);
- the gate terminal (13) of the reset MOS transistor (10) of each one of said light sensitive microcells (4), carried out in the space defined inside the sector (A1) of the corresponding p-n junction (15) between said two adjacent axes (D) intersecting each other.

11. Method for controlling a photomultiplier device (1, 100) of the type according to any of the preceding claims, **characterized in that** it includes the following operations:
- controlling the simultaneous switchover of said interruption components (8) of said plurality of light sensitive microcells (4) from said state of inhibition to said state of conduction, in such a way as to restore the reverse polarization voltage between the cathode (51) and the anode (52) of each one of said avalanche photodiodes (5);
- controlling the simultaneous switchover of said interruption components (8) of said plurality of light sensitive microcells (4) from said state of conduction to said state of inhibition, in such a way as to electrically insulate each one of said avalanche photodiodes (5) from said first electrode (6), said avalanche photodiodes (5) being configured to generate an avalanche current in case of impact of one or more of said photons (F);
- repeating said switchovers according to pre-established time intervals (T).

12. Control method according to claim 11, **characterized in that** it controls said switchover operations through the application of an impulse control input signal (S_{c}) lasting for said pre-established time interval (T) to said gate terminals (13), connected together, of said reset MOS transistors (10) of the photomultiplier device (1, 100) according to any of the claims from 4 to 11, said switchover from said state of inhibition to said state of conduction being carried out at the level of the rising edge of the impulse of said impulse control signal (S_{c}) and said switchover from said state of conduction to said state of inhibition being carried out at the level of the falling edge of the impulse.

13. Control method according to any of the claims 11 or 12, **characterized in that** the extraction of said common output signal (Sₒᵤₜ) is carried out through the AC coupling technique on said gate terminal (13) of said reset MOS transistor (10), or on the Back of said photomultiplier device (1, 100), or on said conductor side (22) of said extraction MOS capacitor (19).

14. Control method according to any of the claims 11 or 12, **characterized in that** the extraction of said common output signal (Sₒᵤₜ) is carried out through the DC reading technique from said drain terminal (12) of said reset MOS transistor (10) at the end of said reset interval (T).

## Patentansprüche

1. Halbleiter-Photomultiplier-Vorrichtung (SiPM) (1) zur Erfassung eines oder mehrerer Photonen (F) des Typs, der eine den besagten Photonen (F) gegenüber empfindliche und auf einem Halbleitersubstrat (3) ausgeführte Oberfläche (2) umfasst, wobei die besagte empfindliche Oberfläche (2) durch eine Vielzahl lichtempfindlicher Mikrozellen (4) definiert ist, die parallel miteinander verbunden sind, so dass sie ein gemeinsames Analog-Ausgabesignal (Sₒᵤₜ) senden, wobei jede der besagten lichtempfindlichen Mikrozellen (4) eine Avalanche-Photodiode (5) umfasst, die zwischen einer ersten Elektrode (6) und einer zweiten Elektrode (7) positioniert ist, welche die besagte Avalanche-Photodiode (5) mit einer Gegenmagnetisierungsspannung versorgen, **dadurch gekennzeichnet, dass** sie für jede der besagten lichtempfindlichen Mikrozellen (4) eine Unterbrechungskomponente (8) zur Unterbrechung der elektrischen Kontinuität umfasst, die zwischen dem Akkumulatorelement (53), das die Lawinenladung der besagten Avalanche-Photodiode (5) speichert, und der besagten ersten Elektrode (6) positioniert ist, wobei die besagten Unterbrechungskomponenten (8) der besagten Vielzahl lichtempfindlicher Mikrozellen (4) so konfiguriert sind, dass sie gleichzeitig aus einem Zustand der Leitung auf einen Zustand der Sperrung umschalten oder umgekehrt.

2. Photomultiplier-Vorrichtung (1) gemäß Patentanspruch 1, **dadurch gekennzeichnet, dass** sie für jede der besagten lichtempfindlichen Mikrozellen (4) eine Quenching-Komponente (9) aufweist, die zwischen der besagten Unterbrechungskomponente (8) und der besagten ersten Elektrode (6) positioniert ist.

3. Photomultiplier-Vorrichtung (1) gemäß eines jeden der vorstehenden Patentansprüche, **dadurch gekennzeichnet, dass** die besagte erste Elektrode (6) und die besagte zweite Elektrode (7) derart von der besagten Vielzahl lichtempfindlicher Mikrozellen (4) geteilt werden, dass die besagten Avalanche-Photodioden (5) der besagten Vielzahl lichtempfindlicher Mikrozellen (4) mit einer gemeinsamen Gegenmagnetisierungsspannung versorgt werden.

4. Photomultiplier-Vorrichtung (1) gemäß eines jeden der vorstehenden Patentansprüche, **dadurch gekennzeichnet, dass** jede der besagten Unterbrechungskomponenten (8) ein MOS-Rückstelltransistor (10) ist, der mit seinem Source-Anschluss (11) an das besagte Akkumulatorelement (53) der besagten Avalanche-Photodiode (5) angeschlossen ist und mit seinem Drain-Anschluss (12) an die besagte erste Elektrode (6), wobei die Gate-Anschlüsse (13) der besagten MOS-Rückstelltransistoren (10) der besagten Vielzahl lichtempfindlicher Mikrozellen (4) miteinander verbunden und dazu konfiguriert sind, ein Impuls-Eingangssteuersignal (S_{c}) für die gleichzeitige Umschaltung der besagten MOS-Rückstelltransistoren (10) aus dem besagten Leitungszustand auf den besagten Sperrungszustand zu empfangen.

5. Photomultiplier-Vorrichtung (1) gemäß Patentanspruch 4, **dadurch gekennzeichnet, dass** jede der besagten lichtempfindlichen Mikrozellen (4) auf dem besagten Halbleitersubstrat (3) angelegt ist, wobei Folgendes in dem besagten Halbleitersubstrat definiert ist:
- der p-n-Übergang (15) der besagten Avalanche-Photodiode (5), definiert durch eine erste, einem ersten Doping-Typ p+ oder n+ unterzogene Schicht (16), über dem eine zweite Schicht (17) definiert ist, die einem bezüglich der besagten ersten Schicht (16) entgegengesetzten Doping-Typ n+ oder p+ unterzogen ist, wobei die besagte zweite Schicht (17) sowohl als Akkumulatorelement (53) der besagten Avalanche-Photodiode (5) als auch als Source-Anschluss (11) des besagten MOS-Rückstelltransistors (10) dient;
- eine dritte Schicht (18), die so ausgeführt ist, dass sie von dem besagten p-n-Übergang (15) distanziert ist und einem Doping-Typ n+ oder p+ unterzogen ist entsprechend der besagten zweiten Schicht (17), so dass sie als Drain-Anschluss (12) des besagten MOS-Rückstelltransistors (10) dient;
- der Gate-Anschluss (13) der besagten MOS-Rückstelltransistoren (10), so ausgeführt, dass er zwischen dem besagten p-n-Übergang (15) und der besagten dritten Schicht (18) dem besagten Halbleitersubstrat (3) überlagert ist.

6. Photomultiplier-Vorrichtung (1) gemäß Patentanspruch 4 oder 5, **dadurch gekennzeichnet, dass** jede der besagten lichtempfindlichen Mikrozellen (4) einen MOS-Extraktionskondensator (19) umfasst, der mit der besagten Avalanche-Photodiode (5) gekoppelt und so konfiguriert ist, dass er die Extraktion des besagten Ausgabesignals (Sₒᵤₜ) aus seiner Leiterseite (22) mittels der Technik der AC-Kopplung erlaubt.

7. Photomultiplier-Vorrichtung (1) gemäß Patentanspruch 6, **dadurch gekennzeichnet, dass** für jede der besagten lichtempfindlichen Mikrozellen (4):
- die Halbleiterseite (20) des besagten MOS-Extraktionskondensators (19) mit dem besagten Source-Anschluss (11) des besagten MOS-Rückstelltransistors (10) zusammenfällt;
- die besagte Leiterseite (22) des besagten MOS-Extraktionskondensators (19) elektrisch von dem besagten Gate-Anschluss (13) des besagten MOS-Rückstelltransistors (10) isoliert ist.

8. Photomultiplier-Vorrichtung (1) gemäß Patentanspruch 7, **dadurch gekennzeichnet, dass** für jede der besagten lichtempfindlichen Mikrozellen (4):
- die besagte Leiterseite (22) des besagten MOS-Extraktionskondensators (19) entlang den Grenzlinien zwischen der besagten lichtempfindlichen Mikrozelle (4) und der danebenliegenden lichtempfindlichen Mikrozelle (4) ausgeführt ist und/oder zwischen den p-n-Übergängen (15) und dem Drain-Anschluss (12) des Rückstelltransistors (10) jeder der besagten lichtempfindlichen Mikrozellen (4), um als ein Element der elektrischen Isolierung zu dienen.

9. Photomultiplier-Vorrichtung (1) gemäß Patentanspruch 4 oder 5, **dadurch gekennzeichnet, dass** sie wenigstens einen Satz (50) aus vier der besagten, lichtempfindlichen Mikrozellen (4) umfasst, die gemäß einer topografischen Ansicht des besagten Satzes (50) innerhalb eines viereckigen Bereichs (A) zusammengefasst sind, in dem Folgendes identifiziert werden kann:
- besagte p-n-Übergänge (15), die so ausgeführt sind, dass sie paarweise nebeneinander liegen auf Ebene der Bereiche (A1), die durch die Überschneidung von zwei innerhalb der besagten viereckigen Bereiche (A) verlaufenden Achsen (D) definiert werden, wobei jeder der besagten p-n-Übergänge (15) die besagte Avalanche-Photodiode (5) und den besagten Source-Anschluss (11) des besagten MOS-Rückstelltransistors (10) einer der besagten lichtempfindlichen Mikrozellen (4) definiert;
- besagte Drain-Anschlüsse (12), die als ein im Schnittpunkt (P) der besagten zwei Achsen (D) definiertes Einzelstück ausgeführt sind;
- besagte Gate-Anschlüsse (13), die miteinander verbunden und dem besagten Halbleitersubstrat (3) zwischen den besagten Drain-Anschlüssen (12) und den besagten Source-Anschlüssen (11) überlagert sind.

10. Photomultiplier-Vorrichtung (1) gemäß eines jeden der Patentansprüche von 6 bis 8, **dadurch gekennzeichnet, dass** sie wenigstens einen Satz (50) aus vier der besagten lichtempfindlichen Mikrozellen (4) umfasst, die gemäß einer topografischen Ansicht des besagten Satzes (50) innerhalb eines viereckigen Bereichs (A) zusammengefasst sind, in dem Folgendes identifiziert werden kann:
- besagte p-n-Übergänge (15), die so ausgeführt sind, dass sie paarweise nebeneinander liegen auf Ebene der Bereiche (A1), die durch die Überschneidung von zwei innerhalb der besagten viereckigen Bereiche (A) verlaufenden Achsen (D) definiert werden, wobei jeder der besagten p-n-Übergänge (15) die besagte Avalanche-Photodiode (5), den besagten Source-Anschluss (11) der besagten MOS-Rückstelltransistoren (10) und die besagte Halbleiterseite (20) des besagten MOS-Extraktionskondensators (19) einer der besagten lichtempfindlichen Mikrozellen (4) definiert;
- besagte Drain-Anschlüsse (12) des besagten MOS-Rückstelltransistors (10), die als im Schnittpunkt (P) der besagten zwei Achsen (D) definierte Einzelstücke angelegt sind;
- die besagte Leiterseite (22) des MOS-Extraktionskondensators (19) jeder der besagten lichtempfindlichen Mikrozellen (4), die gemeinsam mit der danebenliegenden lichtempfindlichen Mikrozelle (4) entlang des Abschnitts der Achse (D) ausgeführt ist, welche sich zwischen den zwei entsprechenden p-n-Übergängen (15) und/oder zwischen jedem der besagten p-n-Übergängen (15) und dem besagten Drain-Anschluss (12) des besagten Rückstelltransistors (10) befindet;
- der Gate-Anschluss (13) des MOS-Rückstelltransistors (10) jeder der besagten lichtempfindlichen Mikrozellen (4), ausgeführt in dem Raum, der innerhalb des Bereichs (A1) des entsprechenden p-n-Übergangs (15) zwischen den besagten zwei nebeneinander liegenden, sich schneidenden Achsen (D) definiert ist.

11. Verfahren zur Steuerung einer Photomultiplier-Vorrichtung (1, 100) des Typs, der einem jeden der vorstehenden Patentansprüche entspricht, **dadurch gekennzeichnet, dass** es folgende Schritte umfasst:
- Steuerung der gleichzeitigen Umschaltung der besagten Unterbrechungskomponenten (8) der besagten Vielzahl lichtempfindlicher Mikrozellen (4) aus dem besagten Zustand der Sperrung auf den besagten Zustand der Leitung, derart, dass die Gegenmagnetisierungsspannung zwischen der Kathode (51) und der Anode (52) jeder der besagten Avalanche-Photodioden (5) wiedergestellt wird;
- Steuerung der gleichzeitigen Umschaltung der besagten Unterbrechungskomponenten (8) der besagten Vielzahl lichtempfindlicher Mikrozellen (4) aus dem besagten Zustand der Leitung auf den besagten Zustand der Sperrung, derart, dass jede der besagten Avalanche-Photodioden (5) elektrisch von der besagten ersten Elektrode (6) isoliert wird, wobei die besagten Avalanche-Photodioden (5) so konfiguriert sind, dass bei Aufprall eines oder mehrerer der besagten Photonen (F) ein Lawinenstrom generiert wird;
- Wiederholung der besagten Umschaltungen gemäß vorbestimmter Zeitintervalle (T).

12. Steuerverfahren gemäß Patentanspruch 11, **dadurch gekennzeichnet, dass** es die besagten Umschaltvorgänge durch Anwendung eines das vorbestimmte Zeitintervall (T) lang andauernden Impuls-Eingangssteuersignals (S_{c}) an die besagten, miteinander verbundenen Gate-Anschlüsse (13) der besagten MOS-Rückstelltransistoren (10) der Photomultiplier-Vorrichtung (1, 100) steuert, gemäß eines jeden der Patentansprüche von 4 bis 11, wobei die besagte Umschaltung aus dem besagten Zustand der Sperrung auf den besagten Zustand der Leitung in Entsprechung der Vorderflanke des Impulses des besagten Impuls-Steuersignals (S_{c}) ausgeführt wird, und die besagte Umschaltung aus dem besagten Zustand der Leitung auf den besagten Zustand der Sperrung in Entsprechung der Rückflanke des Impulses ausgeführt wird.

13. Steuerverfahren gemäß eines jeden der Patentansprüche 11 oder 12, **dadurch gekennzeichnet, dass** die Extraktion des besagten gemeinsamen Ausgabesignals (Sₒᵤₜ) mittels der Technik der AC-Kopplung an dem besagten Gate-Anschluss (13) des besagten MOS-Rückstelltransistors (10), oder an der Rückseite der besagten Photomultiplier-Vorrichtung (1, 100), oder an der besagten Leiterseite (22) des besagten MOS-Extraktionskondensators (19) ausgeführt wird.

14. Steuerverfahren gemäß eines jeden der Patentansprüche 11 oder 12, **dadurch gekennzeichnet, dass** die Extraktion des besagten gemeinsamen Ausgabesignals (Sₒᵤₜ) am Ende des besagten Rückstell-Intervalls (T) mittels der Technik der DC-Erfassung von dem besagten Drain-Anschluss (12) des besagten MOS-Rückstelltransistors (10) ausgeführt wird.

## Revendications

1. Dispositif photomultiplicateur en état solide (SiPM) (1) pour la détection d'un ou plusieurs photons (F) du type comprenant une surface (2) sensible auxdits photons (F) et réalisée sur un substrat semi-conducteur (3), ladite surface sensible (2) étant définie par une pluralité de microcellules sensibles à la lumière (4) reliées entre elles en parallèle de façon à émettre un signal commun analogique de sortie (Sₒᵤₜ), chacune desdites microcellules sensibles à la lumière (4) comprenant une photodiode à avalanche (5) interposée entre une première électrode (6) et une deuxième électrode (7) aptes à fournir à ladite photodiode à avalanche (5) une tension de polarisation inverse, **caractérisé en ce qu'**il prévoit, pour chacune desdites microcellules sensibles à la lumière (4), un composant d'interruption (8) apte à couper la continuité électrique et interposé entre la borne d'accumulation (53) qui accumule la charge de l'avalanche de ladite photodiode à avalanche (5) et ladite première électrode (6), lesdits composants d'interruption (8) de ladite pluralité de microcellules sensibles à la lumière (4) étant configurés de façon à commuter simultanément d'un état de conduction à un état d'inhibition ou vice-versa.

2. Dispositif photomultiplicateur (1) selon la revendication 1, **caractérisé en ce qu'**il prévoit pour chacune desdites microcellules sensibles à la lumière (4) un composant d'extinction (9) interposé entre ledit composant d'interruption (8) et ladite première électrode (6).

3. Dispositif photomultiplicateur (1) selon l'une quelconque des revendications précédentes, **caractérisé en ce que** ladite première électrode (6) et ladite deuxième électrode (7) sont partagées par ladite pluralité de microcellules sensibles à la lumière (4) de façon à fournir auxdites photodiodes à avalanche (5) de ladite pluralité de microcellules sensibles à la lumière (4) une tension commune de polarisation inverse.

4. Dispositif photomultiplicateur (1) selon l'une quelconque des revendications précédentes, **caractérisé en ce que** chacun desdits composants d'interruption (8) est un transistor MOS de réinitialisation (10) relié à ladite borne d'accumulation (53) de ladite photodiode à avalanche (5) avec sa borne de source (11) et à ladite première électrode (6) avec sa borne de drain (12), les bornes de grille (13) dudit transistor MOS de réinitialisation (10) de ladite pluralité de microcellules sensibles à la lumière (4) étant reliées entre elles et étant configurés pour recevoir un signal d'entrée de contrôle des impulsions (S_{c}) pour la commutation simultanée desdits transistors MOS de réinitialisation (10) dudit état de conduction audit état d'inhibition ou vice-versa.

5. Dispositif photomultiplicateur (1) selon la revendication 4, **caractérisé en ce que** chacune desdites microcellules sensibles à la lumière (4) est réalisée sur ledit substrat semi-conducteur (3), où est défini ce qui suit:
- la jonction p-n (15) de ladite photodiode à avalanche (5) définie par une première couche (16) soumise à dopage d'un premier type, p+ ou n+, supérieurement à laquelle une deuxième couche (17) est définie, qui est soumise à dopage du type opposé, n+ ou p+, par rapport à ladite première couche (16), ladite deuxième couche (17) servant aussi bien de borne d'accumulation (53) de ladite photodiode à avalanche (5) que de borne de source (11) dudit transistor MOS de réinitialisation (10);
- une troisième couche (18) réalisée de façon à ce qu'elle est espacée de ladite jonction p-n (15) et soumise à dopage de type n+ ou p+, correspondant à ladite deuxième couche (17) de façon à servir de borne de drain (12) dudit transistor MOS de réinitialisation (10);
- la borne de grille (13) dudit transistor MOS de réinitialisation (10), étant réalisée superposée à ladite couche semi-conductrice (3) entre ladite jonction p-n (15) et ladite troisième couche (18).

6. Dispositif photomultiplicateur (1) selon la revendication 4 ou 5, **caractérisé en ce que** chacune desdites microcellules sensibles à la lumière (4) comprend un condensateur MOS d'extraction (19) accouplé à ladite photodiode à avalanche (5) et configuré pour consentir l'extraction dudit signal de sortie (Sₒᵤₜ) de son côté conducteur (22) au moyen de la technique de couplage AC.

7. Dispositif photomultiplicateur (1) selon la revendication 6, **caractérisé en ce que** pour chacune desdites microcellules sensibles à la lumière (4):
- le côté semi-conducteur (20) dudit condensateur MOS d'extraction (19) coïncide avec ladite borne de source (11) dudit transistor MOS de réinitialisation (10);
- ledit côté conducteur (22) dudit condensateur MOS d'extraction (19) est électriquement isolé de ladite borne de grille (13) dudit transistor MOS de réinitialisation (10).

8. Dispositif photomultiplicateur (1) selon la revendication 7, **caractérisé en ce que** pour chacune desdites microcellules sensibles à la lumière (4):
- ledit côté conducteur (22) dudit condensateur MOS d'extraction (19) est réalisé le long des lignes de délimitation entre ladite microcellule sensible à la lumière (4) et la microcellule sensible à la lumière adjacente (4) et/ou entre les jonctions p-n (15) et la borne de drain (12) du transistor de réinitialisation (10) de chacune desdites microcellules sensibles à la lumière (4) de façon à servir d'un élément d'isolement électrique.

9. Dispositif photomultiplicateur (1) selon la revendication 4 ou 5, **caractérisé en ce qu'**il comprend au moins un groupe (50) comprenant quatre desdites microcellules sensibles à la lumière (4) regroupées, selon une vue topographique dudit groupe (50), à l'intérieur d'une zone quadrangulaire (A) où il est possible de détecter:
- lesdites jonctions p-n (15) réalisées adjacentes à deux à hauteur des secteurs (A1) définis par l'intersection de deux axes (D) passant intérieurement à ladite zone quadrangulaire (A), chacune desdites jonctions p-n (15) définissant ladite photodiode à avalanche (5) et ladite borne de source (11) dudit transistor MOS de réinitialisation (10) d'une desdites microcellules sensibles à la lumière (4);
- lesdites bornes de drain (12) réalisées en tant qu'élément unique défini dans le point (P) d'intersection desdits deux axes (D);
- lesdites bornes de grille (13) reliées entre elles et réalisées superposées audit substrat semi-conducteur (3) entre lesdites bornes de drain (12) et lesdites bornes de source (11).

10. Dispositif photomultiplicateur (1) selon l'une quelconque des revendications de 6 à 8, **caractérisé en ce qu'**il comprend au moins un groupe (50) comprenant quatre desdites microcellules sensibles à la lumière (4) regroupées, selon une vue topographique dudit groupe (50), à l'intérieur d'une zone quadrangulaire (A) où il est possible de détecter:
- lesdites jonctions p-n (15) réalisées adjacentes à deux à hauteur des secteurs (A1) définis par l'intersection de deux axes (D) passant intérieurement à ladite zone quadrangulaire (A), chacune desdites jonctions p-n (15) définissant ladite photodiode à avalanche (5), ladite borne de source (11) dudit transistor MOS de réinitialisation (10) et ledit côté semi-conducteur (20) dudit condensateur MOS d'extraction (19) d'une desdites microcellules sensibles à la lumière (4);
- lesdites bornes de drain (12) dudit transistor MOS de réinitialisation (10) réalisées en tant qu'élément unique défini dans le point (P) d'intersection desdits deux axes (D);
- ledit côté conducteur (22) du condensateur MOS d'extraction (19) de chacune desdites microcellules sensibles à la lumière (4), réalisé en commun avec la microcellule sensible à la lumière adjacente (4) le long de la portion d'axe (D) interposée entre les deux jonctions correspondantes p-n (15) et/ou entre chacune desdites jonctions p-n (15) et ladite borne de drain (12) dudit transistor de réinitialisation (10);
- la borne de grille (13) du transistor MOS de réinitialisation (10) de chacune desdites microcellules sensibles à la lumière (4), réalisée dans l'espace défini à l'intérieur du secteur (A1) de la jonction correspondante p-n (15) entre lesdits deux axes adjacents (D) et croisés entre eux.

11. Méthode de contrôle d'un dispositif photomultiplicateur (1, 100) du type selon l'une quelconque des revendications précédentes, **caractérisée en ce qu'**elle prévoit les opérations suivantes:
- commander la commutation simultanée desdits composants d'interruption (8) de ladite pluralité de microcellules sensibles à la lumière (4) dudit état d'inhibition audit état de conduction, de façon à rétablir la tension de polarisation inverse entre la cathode (51) et l'anode (52) de chacune desdites photodiodes à avalanche (5);
- commander la commutation simultanée desdits composants d'interruption (8) de ladite pluralité de microcellules sensibles à la lumière (4) dudit état de conduction audit état d'inhibition, de façon à isoler électriquement chacune desdites photodiodes à avalanche (5) de ladite première électrode (6), lesdites photodiodes à avalanche (5) étant configurées pour générer un courant d'avalanche au cas d'impact d'un ou de plusieurs desdits photons (F);
- répéter lesdites commutations selon des intervalles de temps préétablis (T).

12. Méthode de contrôle selon la revendication 11, **caractérisée en ce qu'**elle commande lesdites opérations de commutation au moyen de l'application d'un signal d'entrée de contrôle des impulsions (S_{c}) qui dure pour ledit intervalle de temps préétabli (T) auxdites bornes de grille (13), reliées entre elles, desdits transistors MOS de réinitialisation (10) du dispositif photomultiplicateur (1, 100) selon l'une quelconque des revendications de 4 à 11, ladite communication dudit état d'inhibition audit état de conduction étant réalisée à hauteur du bord montant de l'impulsion dudit signal de contrôle des impulsions (S_{c}) et ladite commutation dudit état de conduction audit état d'inhibition étant réalisée à hauteur du bord descendant de l'impulsion.

13. Méthode de contrôle selon l'une quelconque des revendications 11 ou 12, **caractérisée en ce que** l'extraction dudit signal commun de sortie (Sₒᵤₜ) est réalisée au moyen de la technique de couplage AC sur ladite borne de grille (13) dudit transistor MOS de réinitialisation (10), ou sur la partie arrière dudit dispositif photomultiplicateur (1, 100) ou sur ledit côté conducteur (22) dudit condensateur MOS d'extraction (19).

14. Méthode de contrôle selon l'une quelconque des revendications 11 ou 12, **caractérisée en ce que** l'extraction dudit signal commun de sortie (Sₒᵤₜ) est réalisée au moyen de la technique de lecture en courant continu de ladite borne de drain (12) dudit transistor MOS de réinitialisation (10) à la fin dudit intervalle de réinitialisation (T).
